# EUROPEAN PATENT SPECIFICATION

(11) **EP 2 298 041 B1**
(45) Date of publication and mention of the grant of the patent: **09.09.2015**
(21) Application number: 09786492.0
(22) Date of filing: 01.07.2009
(51) Int. Cl.: H05G 2/00

(54) **EXTREME UV RADIATION GENERATING DEVICE COMPRISING A CORROSION-RESISTANT MATERIAL**
VORRICHTUNG ZUR ERZEUGUNG EINER EXTREMEN UV-STRAHLUNG MIT EINEM KORROSIONSFESTEN MATERIAL
DISPOSITIF DE GÉNÉRATION DE RAYONNEMENT UV EXTRÊME COMPRENANT UN MATÉRIAU RÉSISTANT À LA CORROSION

(30) Priority: 07.07.2008 EP 08104652
(43) Date of publication of application: 23.03.2011
(73) Proprietor: Philips Deutschland GmbH, 20099 Hamburg (DE); Koninklijke Philips N.V., 5656 AE Eindhoven (NL); Ushio Denki Kabushiki Kaisha, Tokyo-to (JP)
(72) Inventor: METZMACHER, Christof, NL-5656 AE Eindhoven (NL); WEBER, Achim, NL-5656 AE Eindhoven (NL)
(74) Representative: Bekkers, Joost J.J.
(86) International application number: PCT/IB2009/052853
(87) International publication number: WO 2010/004481

(56) References cited:
- WO-A-2006/093782
- US-A1- 2007 152 175
- US-A1- 2007 230 531

## Description

### FIELD OF THE INVENTION

The invention relates to extreme UV radiation generating devices, especially EUV radiation generating devices which make use of the excitation of a tin-based plasma.

### BACKGROUND OF THE INVENTION

This invention relates to extreme UV radiation generating devices. These devices are believed to play a great role for the upcoming "next generation" lithography tools of the semiconductor industry.

It is known in the art to generate EUV light e.g. by the excitation of a plasma of an EUV source material which plasma may be created by a means of a laser beam irradiating the target material at a plasma initiation site (i.e., Laser Produced Plasma, 'LPP') or may be created by a discharge between electrodes forming a plasma, e.g., at a plasma focus or plasma pinch site (i.e., Discharge Produced Plasma 'DPP') and with a target material delivered to such a site at the time of the discharge.

US 2007/0230531 A1 discloses an arrangement for generating extreme ultraviolet radiation by an electrically operated gas discharge for achieving an improvement in the adjustment of the layer thickness when applying a molten metal to the electrode surfaces and for providing a better protection against the uncontrolled spreading of molten metal into the environment that is associated with an increase in the rotational speed of the electrodes.

WO 2006/093782 A2 discloses a source material dispenser for an EUV light source that comprises a source material reservoir, e.g. tube, that has a wall and is formed with an orifice. The dispenser may comprise an electro-actuatable element, e.g. PZT material, that is spaced from the wall and operable to deform the wall and modulate a release of source material from the dispenser.

US 2007/0152175 A1 discloses a radiation source that generates short-wavelength radiation, such as extreme ultraviolet radiation, for use in lithography. Rotating electrodes are provided which dip into respective baths of liquid metal, for example, tin. An electrical discharge is produced between the electrodes to generate the radiation.

However, in both techniques a flow of liquid tin, which is supposed to be one of the potential target materials, is required, i.e. that certain parts of the EUV generating device are constantly exposed to relatively harsh chemical and physical conditions at elevated temperatures of greater than e.g. 200°C.

To further complicate the situation there is also the prerequisite that the tin needs to be free from contamination in order to secure a high quality of a pure tin plasma.

### SUMMARY OF THE INVENTION

It is an object of the present invention to provide an extreme UV radiation generating device which is capable of providing a less contaminated flow of tin to and from the plasma generating part of said device.

This object is solved by an extreme UV radiation generating device according to claim 1 of the present invention. Accordingly, an extreme UV radiation generating device is provided, comprising a plasma generating device, at least one tin supply system having a supply reservoir in fluid connection with said plasma generating device adapted to supply said plasma generating device with liquid tin, whereby said tin supply system comprises at least one supply means for the supply of tin, whereby said supply means is at least partly coated with at least one covalent inorganic solid material.

The term "plasma generating device" in the sense of the present invention means and/or includes especially any device which is capable of generating and/or exciting a tin-based plasma in order to generate extreme UV light. It should be noted that the plasma generating device of this invention can be any device known in the field to the skilled person.

The term "tin supply system" in the sense of the present invention means and/or includes especially any system capable of generating, containing and/or transporting liquid tin such as e.g. heating vessels, delivery systems and tubings.

The term "supply means" in the sense of the present invention means and/or includes especially at least one vessel and/or at least one reservoir and/or at least one tubing capable of generating, containing and/or transporting liquid tin.

The term "coated" in the sense of the present invention means and/or includes that the part of the supply means which is in direct exposure to the liquid tin when the EUV device is in operation comprises at least partly a material as described in the present invention. The term "coated" is not intended to limit the invention to said embodiments, where a material has been deposited on the supply means (although this is one embodiment of the present invention). It comprises as well embodiments, where the supply means has been treated in order to achieve said coating.

Furthermore the term "coated" is not intended to limit the invention to embodiments, where the supply material is made essentially of one material with only a small "coating" out of the material(s) as described in the present invention. In this invention also embodiments where the supply material essentially comprises a uniform material are meant to be included as well.

The term "covalent inorganic solid material" means a solid material whose elementary constituents have a value in the difference of electronegativity of ≤ 2 (Allred & Rochow), preferably in such a way that the polar or ionic character of the bonding between the elementary constituents is small.

The use of such an extreme UV radiation generating device has shown for a wide range of applications within the present invention to have at least one of the following advantages:
- Due to the coating of the supply means the contamination of tin may be greatly reduced, thus increasing both the lifetime and the quality of the EUV device
- Due to the coating of the supply means the contamination of tin may be greatly reduced, thus increasing the purity ("cleanliness" of the radiation) of the EUV emission itself
- Due to the coating of the supply means the contamination of tin may be greatly reduced, thus maintaining the high quality and purity of the liquid tin itself over a prolonged time, thus avoiding a regular change of the tin itself
- Due to the coating of the supply means the fabrication of the supply means itself becomes cheaper and handling becomes easier (e.g. with respect to mechanics) as the base material can be applied and be coated ready in shape just prior to be used in the EUV device
- Due to the coating of the supply means the supply means itself is insulating, thus being protected against electrical and thermal currents

According to a preferred embodiment of the present invention, at least one covalent inorganic solid material comprises a solid material selected from the group of oxides, nitrides, borides, phosphides, carbides, sulfides, silicides and/or mixtures thereof.

These materials have proven themselves in practice especially due to their good anti-corrosive properties.

According to a preferred embodiment of the present invention, the covalent inorganic solid material comprises at least one material which has a melting point of ≥1000°C.

By doing so especially the long-time performance of the EUV-generating device can be improved.

Preferably the covalent inorganic solid material has a melting point of ≥1000°C, more preferred ≥1500°C and most preferred ≥2000°C.

According to a preferred embodiment of the present invention, the covalent inorganic solid material comprises at least one material which has a density of ≥2g/cm³ and ≤8g/cm³.

By doing so especially the long-time performance of the EUV-generating device can be improved.

Preferably the covalent inorganic solid material comprises at least one material with a density of ≥2.3g/cm³, more preferred ≥4.5/cm³ and most preferred ≥47g/cm³.

According to a preferred embodiment of the present invention, the covalent inorganic solid material comprises at least one material whose atomic structure is based on close packing of at least one of the atomic constituents of ≥ 60%. Package density is defined as the numbers of atomic constituents per unit cell times the volume of a single atomic constituent divided by the geometric volume of the unit cell.

By doing so especially the long-time performance of the EUV-generating device can be improved.

Preferably the covalent inorganic solid material comprises at least one material with a package density of ≥465%, more preferred ≥468% and most preferred ≥470%.

According to a preferred embodiment of the present invention, the covalent inorganic solid material comprises of material which does not show a thermodynamic phase field of atomic constituents and tin in the target temperature range resulting from a chemical reaction between one of the atomic constituents and tin, i.e. the covalent inorganic solid material has a high chemical inertness against liquid tin.

By doing so especially the long-time performance of the EUV-generating device can be improved.

Preferably the covalent inorganic solid material comprises at least one material selected out of the group comprising oxides, nitrides, borides, phosphides, carbides, sulfides, and silicides of Mg, Al, Si, K, Ca, Sc, Ti, V, Cr, Mn, Fe, Co, Ni, Cu, Zn, Ga, Ge, Y, Zr, Nb, Mo, Tc, Ru, Rh, Pd, Ag, Cd, In, Sn, La, Ce, Pr, Nd, Sm, Eu, Gd, Tb, Dy, Ho, Er, Tm, Yb, Lu, Hf, Ta, W, Re, Os, Ir, Pt, Au or mixtures thereof.

The covalent inorganic solid material can be synthesized by rather conventional production techniques, such as physical vapour deposition (PVD), e.g. evaporation, sputtering with and without magnetron and/or plasma assistance, or chemical vapour deposition (CVD), e.g. plasma-enhanced or low-pressure CVD, or molecular beam epitaxy (MBE), or pulsed laser deposition (PLD), or plasma spraying, or etching (chemical passivation), or thermal annealing (thermal passivation), or via melting (e.g. emaille), or galvanic or combinations thereof, e.g. thermo-chemical treatments.

According to a further aspect of the present invention, an extreme UV radiation generating device is provided, comprising a plasma generating device, at least one tin supply system having a supply reservoir in fluid connection with said plasma generating device adapted to supply said plasma generating device with liquid tin, whereby said tin supply system comprises at least one supply means for the supply of tin, whereby said supply means is at least partly coated with at least one metal selected out of the group comprising IVb, Vb, VIb, and/or VIIIb metals or mixtures thereof.

The term "metal" in the sense of the present invention does not mean to be intended to limit the invention to embodiments, where said supply means is coated with a metal in pure form. Actually it is believed at least for a part of the metals according to the present invention that they may form a coating where there are constituents partly oxidized or otherwise reacted.

The use of such an extreme UV radiation generating device has shown for a wide range of applications within the present invention to have at least one of the following advantages:
- Due to the coating of the supply means the contamination of tin may be greatly reduced, thus increasing both the lifetime and the quality of the EUV-device
- Due to the coating of the supply means the contamination of tin may be greatly reduced, thus increasing the purity ("cleanliness" of the radiation) of the EUV emission itself
- Due to the coating of the supply means the contamination of tin may be greatly reduced, thus maintaining the high quality and purity of the liquid tin itself over a prolonged time, thus avoiding a regular change of the tin itself
- Due to the coating of the supply means the fabrication of the supply means itself becomes cheaper and handling becomes easier (e.g. with respect to mechanics) as the base material can be applied and be coated ready in shape just prior to be used in the EUV device
- Due to the coating of the supply means the supply means itself is insulating, thus being protected against electrical and thermal currents
- Due to the metallic coating of the supply means these devices are electrically and thermally conductive which might be an advantage in one or the other embodiment of the invention

According to a preferred embodiment, the thickness of the metallic coating is ≥4100nm and ≤100µm. This is usually a good compromise which has proven itself in practice.

According to a preferred embodiment, the roughness of the metallic coating is ≥1nm and ≤1µm. This has proven well in practice, too.

An extreme UV generating device according to the present invention may be of use in a broad variety of systems and/or applications, amongst them one or more of the following:
- semiconductor lithography
- metrology
- microscopy
- fission
- fusion
- soldering

The aforementioned components, as well as the claimed components and the components to be used in accordance with the invention in the described embodiments, are not subject to any special exceptions with respect to their size, shape, compound selection and technical concept such that the selection criteria known in the pertinent field can be applied without limitations.

### BRIEF DESCRIPTION OF THE DRAWINGS

Additional details, features, characteristics and advantages of the object of the invention are disclosed in the sub claims, the figures and the following description of the respective figures and examples, which --in an exemplary fashion-- show several embodiments and examples of inventive compounds
- Fig. 1: shows a schematic figure of a material test stand which was used to evaluate the inventive (and comparative) examples of the present invention;
- Fig. 2: shows a photograph of a test material prior to immersion;
- Fig. 3: shows a figure showing the corrosion of a material according to a comparative example after 11 days at 300°C in the tin bath.

In order to evaluate different materials and being able to judge to improve the quality of the material with respect to corrosion resistance against liquid tin, a material test stand was built. This device works in vacuum and allows test samples to be dipped into and slightly and slowly move in molten tin for a dedicated period of time.

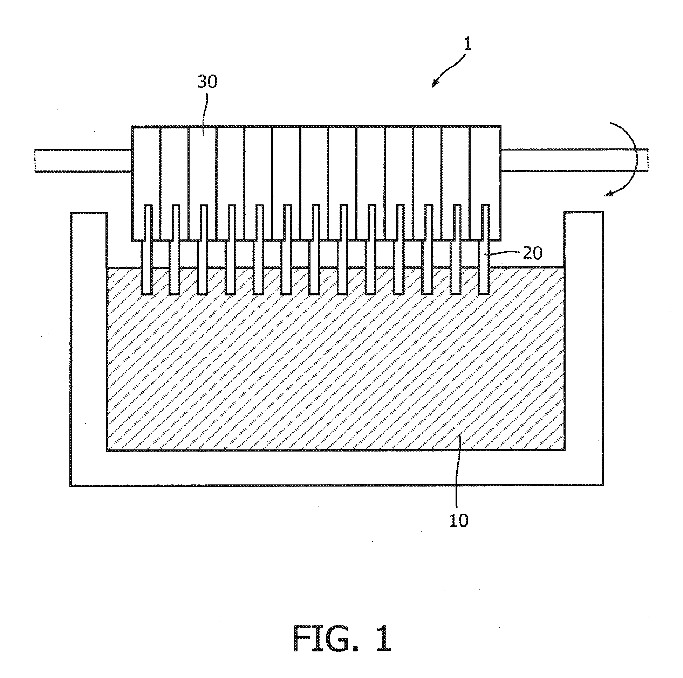

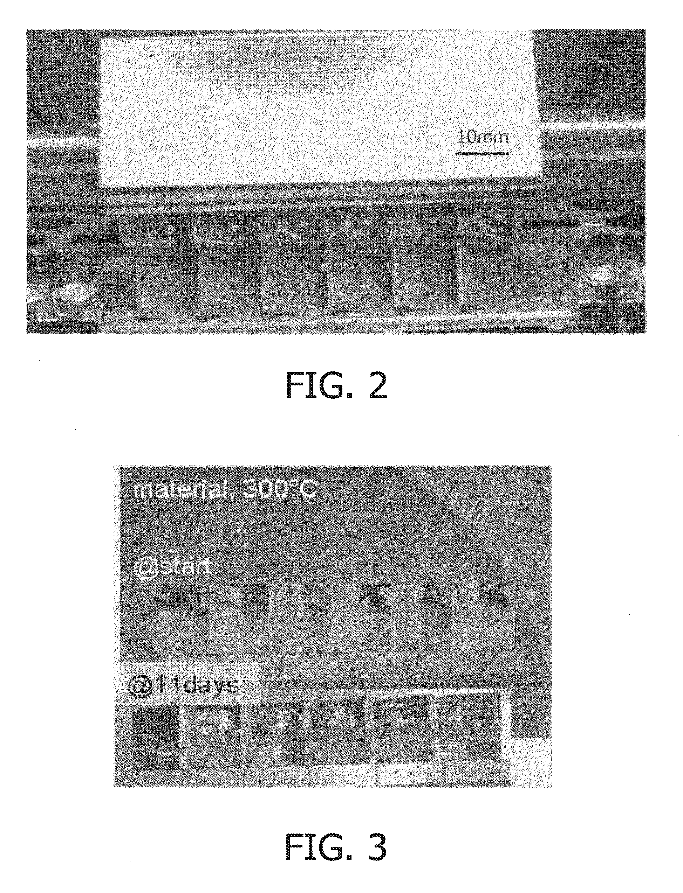

The material test stand 1 is (very schematically) shown in Fig.1 and comprises a tin bath 10, in which several test slides 20 which are mounted on a (turnable) holder 30 can be dipped at a controlled temperature. The dimension of the test slides will be approx. 30 mm x 10 mm. Fig. 2 shows a photo of the test slides prior to immersion.

The temperature and atmosphere of the test stand is continuously logged and controlled.

The samples are investigated macroscopically in dedicated time lags in order to look for hints of failure, e.g., by dissolution of the test material, cracking, colouring, wetting etc.. Moreover, the pure tin in the inert crucible (bath) applied prior to start of sample exposure, is inspected with respect to e.g. appearance of contamination or reaction products, too. During immersion it is possible to observe if and how the wetting behaviour of the material changes. After a dedicated time, e.g. 60 days, of continuous operation, the movement of the test samples is stopped and the test samples are extracted from immersion.

Either macroscopically visibly failed or nominally passed samples of all tested materials are investigated microscopically by light or scanning electron microscopy. By means of this a deeper insight into the nature of failure or non-failure mechanisms and at least an estimation of the so-called corrosion length are possible. Corrosion length is the extrapolated deepness of reaction or affected zone of a material due to the interaction with the liquid tin, related to a time scale, e.g. µm / year. In addition, conventional methods such as weighing or optical profilometry are probable as well. The microscopic investigation results in the conclusion if a tested material is capable of withstanding liquid tin at least for a dedicated time.

The results of the investigation of several inventive and comparative Examples are shown in Table I. The test was made at 300°C for 60 days.

**Table I**

| Material | Inventive /Comparative | Wetting (macrosc.) | Corrosion (microsc.) |
|---|---|---|---|
| Stainless steel | Comparative | Yes | Yes |
| Cast iron | Comparative | Yes | Yes |
| Co base alloys | Comparative | Yes | Yes |
| Cr | Comparative | Yes | Yes |
| Stainless steel, thermically treated to form a covalent oxide layer | Inventive | Yes | No |
| Graphite | Inventive | No | No |
| Mo | Inventive | No | No |
| Ti | Inventive | No | No |
| Co base alloys | Inventive | Yes | No |
| Cr | Inventive | No | No |
| AlN | Inventive | No | No |
| TiAIN | Inventive | No | No |
| TiN | Inventive | No | No |
| TiCN | Inventive | No | No |
| CrN | Inventive | No | No |
| DLC (diamond) | Inventive | No | No |
| α-Si | Inventive | No | No |
| SiO2 | Inventive | No | No |
| SiNx | Inventive | No | No |
| Emaille | Inventive | No | No |
| ZrO₂ | Inventive | No | No |
| FeB, Fe2B | Inventive | No | No |

All inventive compounds show no corrosion and only a few a wetting, even after 60 days. However, in the comparative examples, severe corrosion (sometimes even after a few days) can be seen.

The amount of corrosion of non-inventive compounds can e.g. be seen on Fig. 3, which shows the corrosion on non-treated Stainless steel.

The upper part ("@start") shows the sample just after immersion in the tin bath (approx. 30 minutes). Already there some stains and corrosive leaks can be seen, although to a minor degree.

However, already after 11 days of testing, clear corrosion can be observed, which is shown in the lower part of Fig. 3 ("@testing"). The inventive compounds, on the other hand, show no corrosion after 60 days (and some even after 90 days or more; usually then the test was stopped).

The particular combinations of elements and features in the above detailed embodiments are exemplary only. As those skilled in the art will recognize, variations, modifications, and other implementations of what is described herein can occur to those of ordinary skill in the art without departing from the scope of the invention as claimed. Accordingly, the foregoing description is by way of example only and is not intended as limiting. The invention's scope is defined in the following claims. Furthermore, reference signs used in the description and claims do not limit the scope of the invention as claimed.

## Claims

1. Extreme UV radiation generating device, comprising a plasma generating device, at least one tin supply system having a supply reservoir in fluid communication with said plasma generating device adapted to supply said plasma generating device with liquid tin, whereby said tin supply system comprises at least one supply means for the supply of tin, said supply means including at least one vessel and/or at least one reservoir and/or at least one tubing capable of generating, containing and/or transporting liquid tin, whereby at least the part of said supply means, which is in direct exposure to the liquid tin when the EUV radiation generating device is in operation, is at least partly coated with at least one covalent inorganic solid material.

2. The extreme UV radiation generating device of claim 1, whereby the at least one covalent inorganic solid material comprises a solid material selected from the group of oxides, nitrides, borides, phosphides, carbides, sulfides, silicides and/or mixtures thereof.

3. The extreme UV radiation generating device of claim 1 or 2, whereby the covalent inorganic solid material comprises at least one material which has a melting point of ≥1000°C.

4. The extreme UV radiation generating device of any of the claims 1 to 3, whereby the covalent inorganic solid material comprises at least one material which has a density of ≥2g/cm³ and≤8g/cm³.

5. The extreme UV radiation generating device according to any of the claims 1 to 4, whereby the covalent inorganic solid material comprises at least one material selected out of the group comprising oxides, nitrides, borides, phosphides, carbides, sulfides, and silicides of Mg, Al, Si, K, Ca, Sc, Ti, V, Cr, Mn, Fe, Co, Ni, Cu, Zn, Ga, Ge, Y, Zr, Nb, Mo, Tc, Ru, Rh, Pd, Ag, Cd, In, Sn, La, Ce, Pr, Nd, Sm, Eu, Gd, Tb, Dy, Ho, Er, Tm, Yb, Lu, Hf, Ta, W, Re, Os, Ir, Pt, Au or mixtures thereof.

6. Extreme UV radiation generating device, comprising a plasma generating device, at least one tin supply system having a supply reservoir in fluid communication with said plasma generating device adapted to supply said plasma generating device with liquid tin, whereby said tin supply system comprises at least one supply means for the supply of tin, said supply means including at least one vessel and/or at least one reservoir and/or at least one tubing capable of generating, containing and/or transporting liquid tin, whereby at least the part of said supply means, which is in direct exposure to the liquid tin when the EUV radiation generating device is in operation, is at least partly coated with at least one metal selected out of the group comprising IVb, Vb, VIb, and/or VIIIb metals or mixtures thereof.

7. The extreme UV radiation generating device according to any of the claims 1 to 6, whereby the thickness of the metallic coating is ≥100nm and ≤100µm.

8. The extreme UV radiation generating device according to any of the claims 1 to 7, whereby the roughness of the metallic coating is ≥1nm and ≥1µm.

9. A system comprising an extreme UV radiation generating device of any of the claims 1 to 8, the system being used in one or more of the following applications:
- Semiconductor lithography
- metrology
- microscopy
- fission
- fusion
- soldering.

## Patentansprüche

1. Vorrichtung zur Erzeugung einer extremen UV-Strahlung, umfassend eine Plasmaerzeugungsvorrichtung, mindestens ein Zinn-Zuführungssystem mit einem Zuführungsreservoir in Fluidverbindung mit der genannten Plasmaerzeugungsvorrichtung, das dafür vorgesehen ist, um der genannten Plasmaerzeugungsvorrichtung flüssiges Zinn zuzuführen, wobei das genannte Zinn-Zuführungssystem mindestens ein Zuführungsmittel zum Zuführen von Zinn umfasst, wobei das genannte Zuführungsmittel mindestens ein Gefäß und/oder mindestens ein Reservoir und/oder mindestens eine Schlauchleitung umfasst, welche(s) in der Lage ist, flüssigen Zinn zu erzeugen, aufzunehmen und/oder zu transportieren, wobei mindestens ein Teil des genannten Zuführungsmittels, der dem flüssigen Zinn direkt ausgesetzt ist, wenn die EUV-Strahlung erzeugende Vorrichtung in Betrieb ist, zumindest teilweise mit mindestens einem kovalenten anorganischen Feststoff beschichtet wird.

2. Vorrichtung zur Erzeugung einer extremen UV-Strahlung nach Anspruch 1, wobei der mindestens eine kovalente anorganische Feststoff einen Feststoff ausgewählt aus der Gruppe bestehend aus Oxiden, Nitriden, Boriden, Phosphiden, Carbiden, Sulfiden, Siliziden und/oder Gemische hiervon umfasst.

3. Vorrichtung zur Erzeugung einer extremen UV-Strahlung nach Anspruch 1 oder 2, wobei der kovalente anorganische Feststoff mindestens ein Material umfasst, das einen Schmelzpunkt ≥ 1000 °C hat.

4. Vorrichtung zur Erzeugung einer extremen UV-Strahlung nach Anspruch 1 bis 3, wobei der kovalente anorganische Feststoff mindestens ein Material umfasst, das eine Dichte ≥ 2 g/cm³ und ≤ 8 g/cm³ hat.

5. Vorrichtung zur Erzeugung einer extremen UV-Strahlung nach einem der Ansprüche 1 bis 4, wobei der kovalente anorganische Feststoff mindestens ein Material ausgewählt aus der Gruppe bestehend aus Oxiden, Nitriden, Boriden, Phosphiden, Carbiden, Sulfiden und Siliziden von Mg, Al, Si, K, Ca, Sc, Ti, V, Cr, Mn, Fe, Co, Ni, Cu, Zn, Ga, Ge, Y, Zr, Nb, Mo, Tc, Ru, Rh, Pd, Ag, Cd, In, Sn, La, Ce, Pr, Nd, Sm, Eu, Gd, Tb, Dy, Ho, Er, Tm, Yb, Lu, Hf, Ta, W, Re, Os, Ir, Pt, Au oder Gemischen hiervon umfasst.

6. Vorrichtung zur Erzeugung einer extremen UV-Strahlung, umfassend eine Plasmaerzeugungsvorrichtung, mindestens ein Zinn-Zuführungssystem mit einem Zuführungsreservoir in Fluidverbindung mit der genannten Plasmaerzeugungsvorrichtung, das dafür vorgesehen ist, um der genannten Plasmaerzeugungsvorrichtung flüssiges Zinn zuzuführen, wobei das genannte Zinn-Zuführungssystem mindestens ein Zuführungsmittel zum Zuführen von Zinn umfasst, wobei das genannte Zuführungsmittel mindestens ein Gefäß und/oder mindestens ein Reservoir und/oder mindestens eine Schlauchleitung umfasst, welche(s) in der Lage ist, flüssigen Zinn zu erzeugen, aufzunehmen und/oder zu transportieren, wobei mindestens ein Teil des genannten Zuführungsmittels, der dem flüssigen Zinn direkt ausgesetzt ist, wenn die EUV-Strahlung erzeugende Vorrichtung in Betrieb ist, zumindest teilweise mit mindestens einem Metall ausgewählt aus der Gruppe bestehend aus IVb-, Vb-, VIb- und/oder VIIIb-Metallen oder Gemischen hiervon beschichtet wird.

7. Vorrichtung zur Erzeugung extremer UV-Strahlung nach einem der Ansprüche 1 bis 6, wobei die Dicke der metallischen Beschichtung ≥ 100 nm und ≤ 100 µm ist.

8. Vorrichtung zur Erzeugung extremer UV-Strahlung nach einem der Ansprüche 1 bis 7, wobei die Rauheit der metallischen Beschichtung ≥ 1 nm und ≤ 1 µm ist.

9. System mit einer Vorrichtung zur Erzeugung extremer UV-Strahlung nach einem der Ansprüche 1 bis 8, wobei das System in einer oder mehreren der folgenden Anwendungen eingesetzt wird:
- Halbleiter-Lithographie
- Messtechnik
- Mikroskopie
- Fission (Spaltung)
- Fusion (Verschmelzung)
- Löten.

## Revendications

1. Dispositif de génération de rayonnement UV extrême, comprenant un dispositif de génération de plasma, au moins un système d'alimentation d'étain comportant un réservoir d'alimentation en communication fluidique avec ledit dispositif de génération de plasma apte à fournir de l'étain liquide au dit dispositif de génération de plasma, de telle manière que ledit système d'alimentation d'étain comprenne au moins un moyen d'alimentation pour l'alimentation d'étain, ledit moyen d'alimentation comprenant au moins un récipient et/ou au moins un réservoir et/ou au moins une tubulure capable de générer, de contenir et/ou de transporter de l'étain liquide, de telle manière qu'au moins la partie dudit moyen d'alimentation, qui est exposée directement à l'étain liquide lorsque le dispositif de génération de rayonnement UV extrême est en fonctionnement, soit au moins partiellement recouverte d'au moins un matériau solide inorganique covalent.

2. Dispositif de génération de rayonnement UV extrême selon la revendication 1, de telle manière que l'au moins un matériau solide inorganique covalent comprenne un matériau solide sélectionné dans le groupe d'oxydes, de nitrures, de borures, de phosphures, de carbures, de sulfures, de siliciures et/ou de mélanges de ceux-ci.

3. Dispositif de génération de rayonnement UV extrême selon la revendication 1 ou 2, de telle manière que le matériau solide inorganique covalent comprenne au moins un matériau ayant un point de fusion supérieur ou égal à 1000°C.

4. Dispositif de génération de rayonnement UV extrême selon l'une quelconque des revendications 1 à 3, de telle manière que le matériau solide inorganique covalent comprenne au moins un matériau ayant une densité supérieure ou égale à 2 g/cm³ et inférieure ou égale à 8 g/cm³.

5. Dispositif de génération de rayonnement UV extrême selon l'une quelconque des revendications 1 à 4, de telle manière que le matériau solide inorganique covalent comprenne au moins un matériau sélectionné dans le groupe se composant d'oxydes, de nitrures, de borures, de phosphures, de carbures, de sulfures et de siliciures de Mg, Al, Si, K, Ca, Sc, Ti, V, Cr, Mn, Fe, Co, Ni, Cu, Zn, Ga, Ge, Y, Zr, Nb, Mo, Tc, Ru, Rh, Pd, Ag, Cd, In, Sn, La, Ce, Pr, Nd, Sm, Eu, Gd, Tb, Dy, Ho, Er, Tm, Yb, Lu, Hf, Ta, W, Re, Os, Ir, Pt, Au ou des mélanges de ceux-ci.

6. Dispositif de génération de rayonnement UV extrême, comprenant un dispositif de génération de plasma, au moins un système d'alimentation d'étain comportant un réservoir d'alimentation en communication fluidique avec ledit dispositif de génération de plasma apte à fournir de l'étain liquide au dit dispositif de génération de plasma, de telle manière que ledit système d'alimentation d'étain comprenne au moins un moyen d'alimentation pour l'alimentation d'étain, ledit moyen d'alimentation comprenant au moins un récipient et/ou au moins un réservoir et/ou au moins une tubulure capable de générer, de contenir et/ou de transporter de l'étain liquide, de telle manière qu'au moins la partie dudit moyen d'alimentation, qui est exposée directement à l'étain liquide lorsque le dispositif de génération de rayonnement UV extrême est en fonctionnement, soit au moins partiellement recouverte d'au moins un métal sélectionné dans le groupe se composant de métaux IVb, Vb, VIb et/ou VIIIb ou des mélanges de ceux-ci.

7. Dispositif de génération de rayonnement UV extrême selon l'une quelconque des revendications 1 à 6, de telle manière que l'épaisseur du revêtement métallique soit supérieure ou égale à 100 nm et inférieure ou égale à 100 µm.

8. Dispositif de génération de rayonnement UV extrême selon l'une quelconque des revendications 1 à 7, de telle manière que la rugosité du revêtement métallique soit supérieure ou égale à 1 nm et inférieure ou égale à 1 µm.

9. Système comprenant un dispositif de génération de rayonnement UV extrême selon l'une quelconque des revendications 1 à 8, le système étant utilisé dans l'une ou plusieurs des applications suivantes :
- lithographie à semi-conducteurs ;
- métrologie ;
- microscopie ;
- fission ;
- fusion ;
- soudage.
